# EUROPÄISCHE PATENTSCHRIFT

(11) **EP 4 062 131 B1**
(45) Veröffentlichungstag und Bekanntmachung des Hinweises auf die Patenterteilung: **01.01.2025**
(21) Anmeldenummer: 20804487.5
(22) Anmeldetag: 09.11.2020
(51) Int. Cl.: G01F 23/296, G01F 1/66, G01K 7/38, G01N 9/00, G01N 11/16

(54) **ZUSTANDSÜBERWACHUNG EINES VIBRONISCHEN SENSORS**
MONITORING THE CONDITION OF A VIBRONIC SENSOR
SURVEILLANCE DE L'ÉTAT D'UN CAPTEUR VIBRONIQUE

(30) Priorität: 21.11.2019 DE 102019131485
(43) Veröffentlichungstag der Anmeldung: 28.09.2022
(73) Patentinhaber: Endress+Hauser SE+Co. KG, 79689 Maulburg (DE)
(72) Erfinder: EBRAHIMI, Mohammad Sadegh, 79539 Lörrach (DE); FERRARO, Franco, 79650 Schopfheim (DE); GIRARDEY, Romuald, 68730 Blotzheim (FR); KUHNEN, Raphael, 79418 Schliengen (DE); SANDOR, Izabella, 79650 Schopfheim (DE); WACKER, Ralf, 79585 Steinen (DE)
(74) Vertreter: Koslowski, Christine Adelheid
(86) Internationale Anmeldenummer: PCT/EP2020/081424
(87) Internationale Veröffentlichungsnummer: WO 2021/099151

(56) Entgegenhaltungen:
- EP-A1- 1 502 091
- EP-A2- 1 333 256
- EP-B1- 1 502 091
- DE-A1- 102015 112 421
- DE-A1- 102016 125 243
- DE-A1- 102017 114 315
- DE-A1- 102017 115 147

## Beschreibung

Die Erfindung betrifft ein Verfahren zur Zustandsüberwachung einer Spule, welche Spule Teil einer Vorrichtung zur Bestimmung zumindest einer Prozessgröße eines Mediums in einem Behälter ist, sowie eine zur Durchführung eines erfindungsgemäßen Verfahrens ausgestaltete Vorrichtung. Bei der Vorrichtung handelt es sich um einen vibronischen Sensor. Die Vorrichtung umfasst eine mechanisch schwingfähige Einheit, eine Antriebs-/Empfangseinheit, und eine Elektronikeinheit. Die Prozessgröße ist beispielsweise gegeben durch den Füllstand, insbesondere einen Grenzstand, den Durchfluss des Mediums oder auch durch dessen Dichte oder Viskosität. Das Medium befindet sich beispielsweise in einem Behältnis, z. B. einem Behälter, einem Tank, oder auch in einer Rohrleitung. Das Medium selbst wiederum ist beispielsweise gegeben durch eine Flüssigkeit, ein Gas, oder ein Schüttgut.

Vibronische Sensoren finden vielfach Anwendung in der Prozess- und/oder Automatisierungstechnik. Im Falle von Füllstandsmessgeräten weisen sie zumindest eine mechanisch schwingfähige Einheit, wie beispielsweise eine Schwinggabel, einen Einstab oder eine Membran auf. Diese wird im Betrieb mittels einer Antriebs-/Empfangseinheit, häufig in Form einer elektromechanischen Wandlereinheit, zu mechanischen Schwingungen angeregt, welche wiederum beispielsweise ein piezoelektrischer Antrieb oder ein elektromagnetischer Antrieb sein kann. Entsprechende Feldgeräte werden von der Anmelderin in großer Vielfalt hergestellt und beispielsweise unter der Bezeichnung LIQUIPHANT oder SOLIPHANT vertrieben. Die zugrundeliegenden Messprinzipien sind im Prinzip aus einer Vielzahl von Veröffentlichungen bekannt. Die Antriebs-/Empfangseinheit regt die mechanisch schwingfähige Einheit mittels eines elektrischen Anregesignals zu mechanischen Schwingungen an. Umgekehrt kann die Antriebs-/Empfangseinheit die mechanischen Schwingungen der mechanisch schwingfähigen Einheit empfangen und in ein elektrisches Empfangssignal umwandeln. Bei der Antriebs-/Empfangseinheit handelt es sich entsprechend entweder um eine separate Antriebseinheit und eine separate Empfangseinheit, oder um eine kombinierte Antriebs-/Empfangseinheit. Dabei ist die Antriebs-/Empfangseinheit in vielen Fällen Teil eines rückgekoppelten elektrischen Schwingkreises, mittels welchem die Anregung der mechanisch schwingfähigen Einheit zu mechanischen Schwingungen erfolgt. Beispielsweise muss für eine resonante Schwingung die Schwingkreisbedingung, gemäß welcher der Verstärkungsfaktor ≥1 ist und alle im Schwingkreis auftretenden Phasen ein Vielfaches von 360° ergeben, erfüllt sein. Zur Anregung und Erfüllung der Schwingkreisbedingung muss eine bestimmte Phasenverschiebung zwischen dem Anregesignal und dem Empfangssignal gewährleistet sein. Deshalb wird häufig ein vorgebbarer Wert für die Phasenverschiebung, also ein Sollwert für die Phasenverschiebung zwischen dem Anregesignal und dem Empfangssignal eingestellt. Hierfür sind aus dem Stand der Technik unterschiedlichste Lösungen, sowohl analoge als auch digitale Verfahren, bekannt geworden, wie beispielsweise in den Dokumenten DE102006034105A1, DE102007013557A1, DE102005015547A1, DE102009026685A1, DE102009028022A1, DE102010030982A1 oder DE 102017115147 A1 beschrieben DE 102017115147 A1 offenbart Verfahren zur Zustandsüberwachung einer Spule mit zumindest zwei Anschlussdrähten, welche Spule Teil einer Vorrichtung zur Bestimmung zumindest einer Prozessgröße eines Mediums in einem Behälter ist. Das Verfahren aus diesem Dokument umfasst die Bestimmung eines Sollwertes eines ohmschen Gesamtwiderstandes für die Spule und die Anschlussdrähte und zur Bestimmung einer Zustandsanzeige der Spule.

Sowohl das Anregesignal als auch das Empfangssignal sind charakterisiert durch ihre Frequenz ω, Amplitude A und/oder Phase Φ. Entsprechend werden Änderungen in diesen Größen üblicherweise zur Bestimmung der jeweiligen Prozessgröße herangezogen. Bei der Prozessgröße kann es sich beispielsweise um einen Füllstand, einen vorgegebenen Füllstand, oder auch um die Dichte oder die Viskosität des Mediums, sowie um den Durchfluss handeln. Bei einem vibronischen Grenzstandschalters für Flüssigkeiten wird beispielsweise unterschieden, ob die schwingfähige Einheit von der Flüssigkeit bedeckt ist oder frei schwingt. Diese beiden Zustände, der Freizustand und der Bedecktzustand, werden dabei beispielsweise anhand unterschiedlicher Resonanzfrequenzen, also anhand einer Frequenzverschiebung, unterschieden.

Die Dichte und/oder Viskosität wiederum lassen sich mit einem derartigen Messgerät nur ermitteln, wenn die schwingfähige Einheit vom Medium bedeckt ist. Im Zusammenhang mit der Bestimmung der Dichte und/oder Viskosität sind ebenfalls unterschiedliche Möglichkeiten aus dem Stand der Technik bekannt geworden, wie beispielswiese die in den Dokumenten DE10050299A1, DE102007043811A1, DE10057974A1, DE102006033819A1, DE102015102834A1 oder DE102016112743A1 offenbarten.

Für die Antriebs-/Empfangseinheit selbst werden insbesondere piezoelektrische und/oder elektromagnetische Antriebs-/Empfangseinheiten verwendet. Bei auf dem piezoelektrischen Effekt basierenden Antriebs-/Empfangseinheiten kann in der Regel ein vergleichsweise hoher Wirkungsgrad erzielt werden. Sie sind jedoch für den Einsatz bei hohen Temperaturen, insbesondere bei Temperaturen über 300 °C nur bedingt geeignet. Eine Alternative ist in diesem Zusammenhang gegeben durch elektromagnetische Antriebs-/Empfangseinheiten gegeben, wie beispielsweise in den Druckschriften WO2007/113011, WO2007/114950 A1, DE102015104533A1, DE102016112308A1 beschrieben. Die Umwandlung elektrischer Energie in mechanische Energie erfolgt hier jeweils über ein Magnetfeld. Die beschriebenen Wandlereinheiten umfassen deshalb üblicherweise zumindest eine Spule und einen Permanentmagneten. Mittels der Spule wird ein den Magnet durchsetzendes magnetisches Wechselfeld erzeugt und über den Magneten eine periodische Kraft auf die schwingfähige Einheit übertragen. Eine derartige Antriebs-/Empfangseinheit ist je nach verwendeten Materialien beispielsweise für einen Temperaturbereich zwischen -200°C und 500°C einsetzbar.

Um das zuverlässige Arbeiten eines vibronischen Sensors zu gewährleisten, sind aus dem Stand der Technik verschiedenste Verfahren zur Diagnose möglicher Fehlfunktionen eines vibronischen Sensors bekannt geworden. Die Möglichkeit einer Zustandsüberwachung oder Diagnose ist insbesondere im Falle von sicherheitskritischen Anwendungen, wie beispielsweise einem Einsatz eines Grenzstandschalters in einem mit einer brennbaren Flüssigkeit gefüllten Behälter, von großer Bedeutung. Je nach konkreter Anwendung muss das jeweilige Messgerät unterschiedlichen Sicherheitsanforderungen genügen. In dieser Hinsicht ist beispielsweise der sogenannte SIL-Standard (SIL steht für Safety Integrity Level) gemäß der Normvorschrift IEC61508 bekannt geworden, welcher zwischen vier unterschiedlichen Stufen zur Spezifizierung der Anforderung für die Sicherheitsintegrität von Sicherheitsfunktionen unterscheidet. Die Sicherheitsanforderungsstufe stellt dabei im Prinzip ein Maß für die Zuverlässigkeit des jeweiligen Systems bzw. Messgeräts in Abhängigkeit von einer potentiellen Gefährdung dar. Typischerweise bereitgestellte Sicherheitsfunktionen zur Gewährleistung eines bestimmten Levels für die Sicherheitsintegrität sind beispielsweise gegeben durch Notausschaltungen, oder das Abschalten überhitzter Geräte.

Zur Festlegung eines Sicherheitsintegritätslevels wird beispielsweise das Ausfallverhalten einzelner Baugruppen untersucht. Weiterhin wird das Vorliegen redundanter Strukturen geprüft, sowie das Verhältnis zwischen sicheren und unsicheren, bzw. gefährlichen, Fehlern. Aus derartigen Überlegungen kann dann eine Gesamt-Ausfallrate bestimmt werden, anhand welcher dem jeweiligen System bzw. Messgerät das jeweilige Sicherheitsintegritätslevel zugeordnet wird. Die DE102004027397A1 beschreibt eine Möglichkeit zur Detektion eines Kabelbruchs in einem vibronischen Sensor. Aus den Dokumenten DE10014724A1 und DE102009045204A1 sind Diagnosemöglichkeiten zur Erkennung von Ansatz im Bereich der schwingfähigen Einheit bekannt geworden. Aber auch Diagnosen im Bereich der Antriebs-/Empfangseinheit eines vibronischen Sensors wurden in unterschiedlichsten Ausgestaltungen vorgeschlagen, wie beispielsweise die in der DE102008032887A1 beschriebene Diagnose einer piezoelektrischen Antriebs-/Empfangseinheit. In Bezug auf eine elektromagnetische Antriebs-/Empfangseinheit ist es wiederum aus der DE102017115147A1 bekannt geworden, den Zustand der Antriebs-/Empfangseinheit anhand des ohmschen Gesamtwiderstands zu beurteilen.

Ausgehend vom Stand der Technik liegt der vorliegenden Erfindung die Aufgabe zugrunde, ein Messgerät bereitzustellen, mit welchem auf besonders einfache Weise hohen Sicherheitsanforderungen genügt werden kann.

Diese Aufgabe wird gelöst durch das Verfahren nach Anspruch 1 sowie durch die Vorrichtung nach Anspruch 11.

Hinsichtlich des Verfahrens wird die Aufgabe gelöst durch ein Verfahren zur Zustandsüberwachung einer Spule, welche Spule Teil einer Vorrichtung zur Bestimmung zumindest einer Prozessgröße eines Mediums in einem Behälter ist. Das Verfahren umfasst folgende Verfahrensschritte:
- Beaufschlagen der Spule mit einem elektrischen Anregesignal und Empfangen eines elektrischen Empfangssignals von der Spule,
- Ermitteln eines ersten Werts für das Empfangssignal zu einem ersten vorgebbaren Messzeitpunkt,
- Vergleichen des ersten Werts für das Empfangssignals zu dem ersten Messzeitpunkt mit einem Referenzwert, und
- Ermitteln eines Zustandsindikators für die Spule anhand des Vergleichs,

wobei es sich bei dem Zustandsindikator um eine Aussage über eine mangelhafte elektrische Kontaktierung oder um einen Kabelbruch im Bereich der Spule oder von zumindest zwei Anschlussdrähten handelt,
wobei das Vorliegen einer mangelhaften elektrischen Kontaktierung oder eines Kabelbruchs im Bereich der Spule anhand einer Abweichung der Sprungantwort des Empfangssignals in Reaktion auf die sprunghafte Änderung des Anregesignals von einer Referenzsprungantwort erkannt wird.

Insbesondere weist die Sprungantwort des Empfangssignals im Falle einer intakten Spule einen exponentiellen Verlauf auf. In diesem Falle weist eine Abweichung von einem derartigen Verlauf auf das Vorliegen einer mangelhaften elektrischen Kontaktierung hin.

Die Diagnose der Antriebs-/Empfangseinheit über einen Vergleich eines Messwerts zu einem vorgebbaren ersten Messzeitpunkt mit einem Referenzwert ist auf besonders einfache Art und Weise realisierbar. Insbesondere ist der konstruktive Aufwand sehr gering - die Implementierung der Zustandsüberwachung erfordert nur sehr wenige zusätzliche Bauteile für den jeweiligen Sensor.

Es ist von Vorteil, wenn der erste vorgebbare Messzeitpunkt so gewählt wird, dass er in einem vorgebbaren ersten Zeitintervall liegt, in welchem das Empfangssignal in Form einer Sprungantwort auf eine sprunghafte Änderung des Anregesignals reagiert. Eine Sprungantwort ist vorteilhaft besonders leicht auszuwerten. Sie geht mit einem charakteristischen Verlauf des Empfangssignals als Funktion der Zeit einher, der sich auf einfache Art und Weise detektieren lässt.

Es ist ebenfalls von Vorteil, wenn es sich bei dem Anregesignal um ein Rechtecksignal handelt. Ein Rechtecksignal ist gekennzeichnet durch einen periodischen Wechsel zwischen zwei konstanten Werten, welches als Funktion der Zeit aufgetragen einen rechteckförmigen Verlauf aufweist. Es ist somit charakterisiert durch periodische aufsteigende und abfallende Flanken. In diesem Zusammenhang ist es weiterhin von Vorteil, wenn es sich bei der sprunghaften Änderung des Anregesignals um eine aufsteigende oder absinkende Flanke des Anregesignals handelt.

Bevorzugt wird eine Aussage über ein Ausmaß einer Beschädigung an der Spule ermittelt. Es ist also nicht nur eine qualitative, sondern auch eine quantitative Aussage über den Zustand der Spule möglich. In Abhängigkeit der anhand des Zustandsindikators gefällten Diagnose über den Zustand der Spule ist es ferner denkbar, Meldungen zu generieren, beispielsweise über eine durchzuführende Wartung oder über das Vorliegen eines Defekts.

Ebenfalls bevorzugt ist es, den Zustandsindikator in Abhängigkeit der Abweichung des gemessenen Werts von dem Referenzwert zu ermitteln. Insbesondere ist es möglich zu überprüfen, ob die Abweichung einen vorgebbaren Grenzwert überschreitet.

Gemäß einer Ausgestaltung des Verfahrens handelt es sich bei dem Zustandsindikator um eine Aussage über das Vorliegen zumindest eines Windungsschlusses im Bereich der Spule.

In dieser Hinsicht ist es von Vorteil, wenn das Vorliegen eines Windungsschlusses im Bereich der Spule anhand eines Unterschreitens des Referenzwerts zum ersten vorgebbaren Messzeitpunkt erkannt wird.

In einer Ausgestaltung beinhaltet das Verfahren, dass ein zweiter Wert für das Empfangssignal zu einem zweiten vorgebbaren Messzeitpunkt ermittelt wird, und wobei anhand des zweiten Werts für das Empfangssignal eine Aussage über eine Temperatur des Mediums ermittelt wird. Neben der Zustandsüberwachung erlaubt das erfindungsgemäße Verfahren eine Bestimmung der Temperatur ohne die Implementierung eines weiteren temperaturempfindlichen Sensorelements.

Die Temperatur im Bereich eines vibronischen Sensors jeweils des Mediums hat einen großen Einfluss auf die Bestimmung der jeweiligen Prozessgröße, insbesondere auf das jeweils empfangene Empfangssignal. Um diesen Einfluss zu kompensieren, ist es aus der DE102006007199A1 oder DE102009029490A1 bekannt geworden, ein vibronisches Messgerät mit einem zusätzlichen Temperatursensor zu versehen. Die Integration eines weiteren Sensors in ein Messgerät ist allerdings grundsätzlich mit einem gewissen konstruktiven Aufwand verbunden. Aus der DE102017114315A1 ist es hinsichtlich einer elektromagnetischen Antriebs-/Empfangseinheit wiederum bekannt geworden, die Temperatur des Mediums anhand einer elektrischen Kenngröße, beispielsweise anhand des ohmschen Widerstands, der Spule zu bestimmen. Aber auch eine solche Maßnahme ist mit einem vergleichsweise hohen Aufwand verbunden, da Mittel zur Bestimmung der jeweiligen Kenngröße bereitzustellen sind. Die erfindungsgemäße Temperaturbestimmung anhand eines zweiten Werts für das Empfangssignal zu einem zweiten vorgebbaren Messzeitpunkt ist dagegen auf besonders einfache Art und Weise realisierbar. Dieser zweite Wert für das Empfangssignal bzw. der zweite vorgebbare Messzeitpunkt ist derart gewählt, dass der zweite Messwert eine direkte Abhängigkeit von der Temperatur des Mediums aufweist und zur Temperaturbestimmung direkt herangezogen werden kann. So sind keine weiteren Sensorelemente oder aufwendige konstruktive Maßnahmen zur Temperaturbestimmung notwendig.

Es ist mit Hinblick auf die Temperatur des Mediums auch denkbar, dass der Einfluss der Temperatur auf das Empfangssignal im fortlaufenden Messbetrieb der Vorrichtung kompensiert wird. Auf diese Weise kann die Messgenauigkeit des jeweiligen Sensors bei der Ermittlung der jeweiligen Prozessgröße erhöht werden.

In diesem Zusammenhang ist es von Vorteil, wenn die Temperatur des Mediums anhand eines Vergleichs des zweiten Werts für das Empfangssignals mit zumindest einer Kennlinie des Empfangssignals als Funktion der Temperatur ermittelt wird.

Es ist ebenfalls von Vorteil, wenn der zweite vorgebbare Messzeitpunkt so gewählt wird, dass er außerhalb des ersten Zeitintervalls liegt.

Bevorzugt wird der zweite vorgebbare Messzeitpunkt so gewählt, dass er innerhalb eines zweiten Zeitintervalls liegt, in welchem das Empfangssignal im Wesentlichen konstant ist.

Die der Erfindung zugrunde liegende Aufgabe wird ferner gelöst durch eine Vorrichtung zur Bestimmung und/oder Überwachung zumindest einer Prozessgröße eines Mediums in einem Behältnis, umfassend zumindest eine Spule, welche Vorrichtung dazu ausgestaltet ist, ein Verfahren nach zumindest einer der beschriebenen Ausgestaltungen durchzuführen. Das erfindungsgemäße Verfahren kann dabei gleichzeitig zum fortlaufenden Messbetrieb oder abwechselnd mit dem fortlaufenden Betrieb während eines Diagnosebetriebsmodus der Vorrichtung durchgeführt werden. Denkbar ist auch eine manuelle, punktuelle Auslösung des Verfahrens, beispielsweise durch einen Schaltvorgang oder ähnliches.

Bezüglich der Vorrichtung ist es von Vorteil, wenn es sich bei der Vorrichtung um einen vibronischen Sensor umfassend eine mechanisch schwingfähige Einheit, eine Antriebs-/Empfangseinheit mit zumindest einer Spule, welche Antriebs-/Empfangseinheit dazu ausgestaltet ist, die mechanisch schwingfähige Einheit mittels eines elektrischen Anregesignals zu mechanischen Schwingungen anzuregen und die mechanischen Schwingungen von der schwingfähigen Einheit zu empfangen und in ein elektrisches Empfangssignal umzuwandeln, und eine Elektronikeinheit, welche dazu ausgestaltet ist, ausgehend vom Empfangssignal das Anregesignal zu erzeugen, und aus dem Empfangssignal die zumindest eine Prozessgröße zu ermitteln, handelt.

In einer Ausgestaltung der Vorrichtung handelt es sich bei der schwingfähigen Einheit um eine Membran, um einen Einstab oder um eine Schwinggabel.

Eine weitere Ausgestaltung der Vorrichtung beinhaltet, dass es sich bei der Prozessgröße um einen, insbesondere vorgebbaren, Füllstand, um die Dichte oder die Viskosität des Mediums handelt.

Im Rahmen der vorliegenden Erfindung können unterschiedlichste Ausgestaltungen eines vibronischen Sensors, insbesondere unterschiedliche Antriebs-/Empfangseinheiten, verwendet werden. Im Folgenden sind ohne Beschränkung der Allgemeinheit zwei besonders bevorzugte Ausgestaltungen für eine Antriebs-/Empfangseinheit angegeben.

In einer Ausgestaltung umfasst die Antriebs-/Empfangseinheit zumindest
- eine in mechanische Schwingungen versetzbare Membran,
- zwei senkrecht zu einer Grundfläche der Membran an der Membran befestigte Stangen,
- ein Gehäuse, wobei die Membran zumindest einen Teilbereich einer Wandung des Gehäuses bildet, und wobei die beiden Stangen ins Gehäuseinnere hineinreichen,
- zwei Magnete, wobei jeweils ein Magnet in dem der Membran abgewandten Endbereich jeweils einer der beiden Stangen befestigt ist, und
- eine Spule mit Kern, welche innerhalb des Gehäuses oberhalb der Magnete befestigt ist, und welche Spule mit einem elektrischen Wechselstromsignal beaufschlagbar ist,
   wobei die Spule dazu ausgestaltet ist, ein Magnetfeld zu erzeugen, welches Magnetfeld die beiden Stangen mittels der beiden Magnete in mechanische Schwingungen versetzt, und
   wobei die beiden Stangen derart an der Membran befestigt sind, dass aus den Schwingungen der beiden Stangen Schwingungen der Membran resultieren.

In einer weiteren Ausgestaltung umfasst die Antriebs-/Empfangseinheit zumindest
- eine in mechanische Schwingungen versetzbare Membran,
- zumindest drei senkrecht zu einer Grundfläche der Membran an der Membran befestigte Stangen,
- ein Gehäuse, wobei die Membran zumindest einen Teilbereich einer Wandung des Gehäuses bildet, und wobei die Stangen ins Gehäuseinnere hineinreichen,
- zumindest drei Magnete, wobei jeweils ein Magnet in dem der Membran abgewandten Endbereich an jeder der zumindest drei Stangen befestigt ist, und
- eine Spule mit Kern, welche innerhalb des Gehäuses oberhalb der Magnete befestigt ist, und welche Spule mit einem elektrischen Wechselstromsignal beaufschlagbar ist,

wobei die Spule dazu ausgestaltet ist, ein Magnetfeld zu erzeugen, welches Magnetfeld die Stangen mittels der Magnete in mechanische Schwingungen versetzt,
wobei die Stangen derart an der Membran befestigt sind, dass aus den Schwingungen der Stangen Schwingungen der Membran resultieren,
wobei zumindest eine der Stangen im Wesentlichen an einem Ort entlang der Grundfläche der Membran an der Membran befestigt ist,
an welchem Ort die zweite Ableitung der Auslenkung der Membran aus einer Ruheposition, als Funktion des Orts auf der Grundfläche im Wesentlichen null ist.

Besonders bevorzugt ist darüber hinaus eine Antriebs-/Empfangseinheit nach einer der beiden beispielhaft beschriebenen Ausgestaltungen mit vier Stangen.

Ferner sei darauf verwiesen, dass die in Zusammenhang mit dem erfindungsgemäßen Verfahren beschriebenen Ausgestaltungen mutatis mutandis auch auf die erfindungsgemäße Vorrichtung anwendbar sind und umgekehrt.

Die Erfindung sowie ihre vorteilhaften Ausgestaltungen werden nachfolgend anhand der Figuren Fig. 1 - Fig. 4 näher beschrieben. Es zeigt:
Fig. 1: eine Darstellung eines vibronischen Sensors gemäß Stand der Technik,
Fig. 2: zwei mögliche Ausgestaltungen eines vibronischen Sensors mit bevorzugten elektromagnetischen Antriebs-/Empfangseinheiten,
Fig. 3 ein Diagramm des Empfangssignals der Spule zur Illustrierung der erfindungsgemäßen Zustandsüberwachung; und
Fig. 4 ein Diagramm des Empfangssignals der Spule zur Illustrierung der erfindungsgemäßen Temperaturbestimmung.

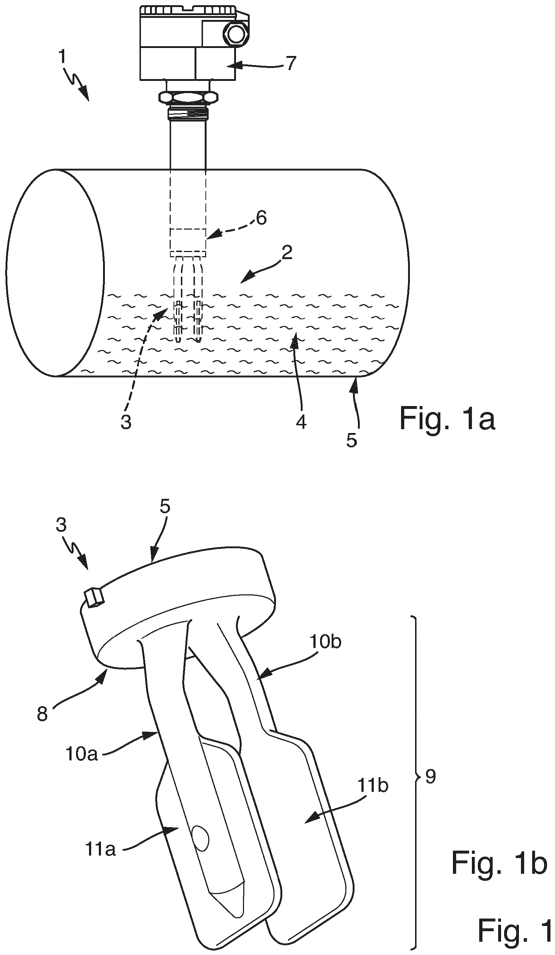

In Fig. 1a ist ein vibronisches Füllstandsmessgerät 1 gezeigt. Eine Sensoreinheit 2 mit einer mechanisch schwingfähigen Einheit 3 in Form einer Schwinggabel taucht teilweise in ein Medium 4 ein, welches sich in einem Behälter 5 befindet. Die schwingfähige Einheit 3 wird mittels der Antriebs-/Empfangseinheit 6, in der Regel einer elektromechanischen Wandlereinheit, zu mechanischen Schwingungen angeregt, und kann beispielsweise ein piezoelektrischer Stapel- oder Bimorphantrieb, aber auch eine elektromagnetische oder auch magnetostriktive Antriebs-/Empfangseinheit sein. Es versteht sich jedoch von selbst, dass auch andere Ausgestaltungen eines vibronischen Füllstandsmessgeräts möglich sind. Weiterhin ist eine Elektronikeinheit 7 dargestellt, mittels welcher die Signalerfassung, -auswertung und/oder-speisung erfolgt.

Fig. 1b zeigt eine detailliertere Ansicht einer schwingfähigen Einheit 3 in Form einer Schwinggabel, wie sie beispielsweise für den von der Anmelderin unter der Bezeichnung LIQUIPHANT vertriebenen vibronischen Sensor eingesetzt wird. Zu sehen ist eine Membran 8, und ein damit verbundene Schwingelemente 9. Das Schwingelement 9 weist zwei Schwingstäbe 10a, 10b auf, an welchen endseitig jeweils ein Paddel 11a, 11b angeformt ist. Im Betrieb führt die Schwinggabel 3 Schwingungsbewegungen entsprechend der Schwingungsmode, mit welcher sie angeregt wird, aus. Jeder der beiden Schwingstäbe 10a, 10b verhält sich im Wesentlichen wie ein sogenannter Biegeschwinger. In der Grundschwingungsmode schwingen die beiden Schwingstäbe 10a, 10b beispielsweise gegenphasig zueinander.

Obgleich im Rahmen der vorliegenden Erfindung zahlreiche unterschiedliche Ausgestaltungen für die Antriebs-/Empfangseinheit 6 verwendet werden können, bezieht sich die nachfolgende Beschreibung ohne Beschränkung der Allgemeinheit auf elektromagnetische Antriebs-/Empfangseinheiten 6 mit zumindest einer Spule, wie sie in den Dokumenten DE102015104533A1 oder DE102016112308A1 beschrieben sind.

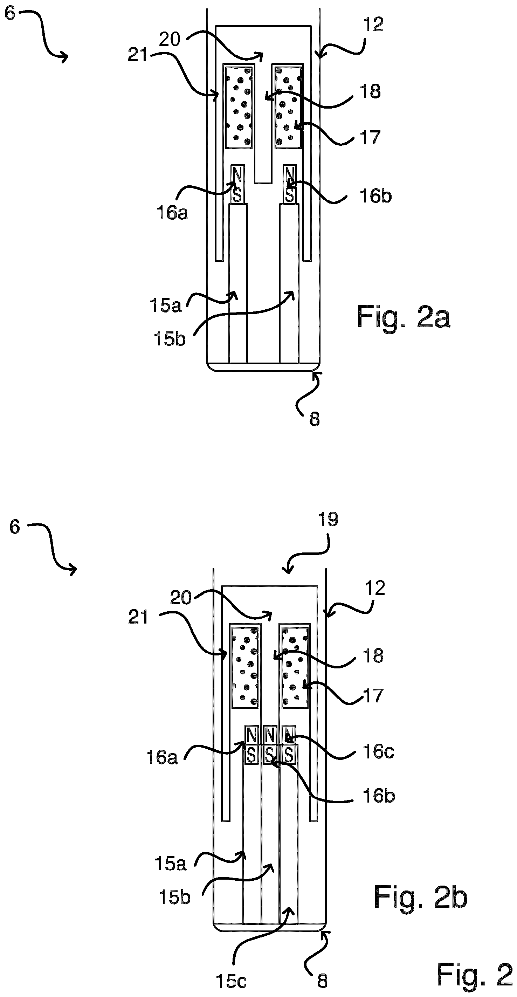

In Fig. 2a ist eine schematische Ansicht einer derartigen Antriebs-/Empfangseinheit 6 gezeigt. Ein Gehäuse 12 schließt mit der unteren Wandung mit einer Membran 8 ab, welche der schwingfähigen Einheit 3 zuzuordnen ist. Für die hier gezeigte Ausgestaltung ist das Gehäuse 12 zylinderförmig und die scheibenförmige Membran 8 hat eine kreisrunde Querschnittsfläche A. Es versteht sich jedoch von selbst, dass auch andere Geometrien denkbar sind und unter die vorliegende Erfindung fallen. Senkrecht zur Grundfläche A der Membran 8 und ins Innere des Gehäuses 12 hineinreichend sind zwei Stangen 15a, 15b an der Membran 8 befestigt. Dabei handelt es sich insbesondere um eine kraftschlüssige Verbindung. Die Grundfläche Ader Membran 8 liegt dann in einer Ebene senkrecht zur Längsrichtung der Stangen 15a, 15b.

In dem der Membran 8 abgewandten Endbereich der Stangen 15a, 15b ist jeweils ein Magnet 16a, 16b insbesondere ein SmCo- oder Alnico-Magnet, befestigt. Die Magnete 16a, 16b sind bevorzugt alle gleich ausgerichtet bzw. orientiert. Oberhalb der Magnete 16a, 16b ist eine Spule 17 angeordnet, welche einen um den Kern 18 gewickelten Draht umfasst. Der Kern 18 der Spule 17 ist Teil einer topfförmigen Ankereinheit 19 mit einem Boden 20 sowie einer Umfangswandung 21. Beispielsweise kann der Boden 20 ebenso wie die Grundfläche A der Membran 8 eine kreisförmige Querschnittsfläche aufweisen. Vom Boden 20 der topfförmigen Ankereinheit 19 reicht der Kern 18 der Spule 17 in Form eines Stutzens zentrisch ins Innere der Ankereinheit 19. Die Umfangswandung 21 hat in diesem Falle dann die Funktion einer magnetischen Feldrückführung inne. Die Stangen 15a, 15b mit den Magneten 16a und 16b berühren die Spule 17 und den Kern 18 nicht. Die Spule 17 wird im fortlaufenden Betrieb zur Erzeugung eines magnetischen Wechselfeldes mit einem Wechselstromsignal beaufschlagt. Hierzu verfügt die Spule über zwei in Fig. 2a nicht gezeigte Anschlussdrähte.

Aufgrund des Wechselfeldes werden die Stangen 15a und 15b über die Magnete 16a und 16b horizontal, d. h. senkrecht oder quer zu ihrer Längsachse, ausgelenkt derart, dass sie in Schwingungen versetzt werden. Einerseits haben die Stangen 15a und 15b dann eine Hebelwirkung, durch welche die durch die horizontale Auslenkung erzeugte Biegung der Stangen 15a und 15b auf die Membran 8 übertragen wird derart, dass die Membran 8 in Schwingungen versetzt wird. Andererseits handelt es sich bei der Kombination aus den beiden Stangen 15a und 15b sowie der Membran 8 aber um einen eigenen Resonator.

Fig. 2b zeigt eine elektromechanische Wandlereinheit 6 ähnlich wie in Fig. 2a mit dem Unterschied, dass gemäß Fig. 2b drei Stangen 15a-15c sowie drei Magnete 16a-16c vorhanden sind, wie in der DE102016112308A1 offenbart. Die elektromechanische Wandlereinheit kann aber auch über vier oder mehr Stangen verfügen.

Im Falle der Ausgestaltungen aus Fig. 2 bilden die beiden Schwingstäbe 10a, 10b der mechanisch schwingfähige Einheit 3 sowie die Stangen 15a-15c der Wandlereinheit 6 jeweils mit der Membran 8 einen mechanischen Resonator. Dabei ist die Membran 8 bevorzugt, aber nicht notwendigerweise, einstückig ausgestaltet. Insbesondere kann sie sowohl der schwingfähigen Einheit 3 als auch der Wandlereinheit 6 zugeordnet werden.

Erfindungsgemäß wird eine Zustandsüberwachung eines vibronischen Sensors durchgeführt, bei welcher anhand eines Vergleichs eines ersten Werts des Empfangssignals zu einem vorgebbaren ersten Messzeitpunkt mit einem Referenzwert verglichen wird.

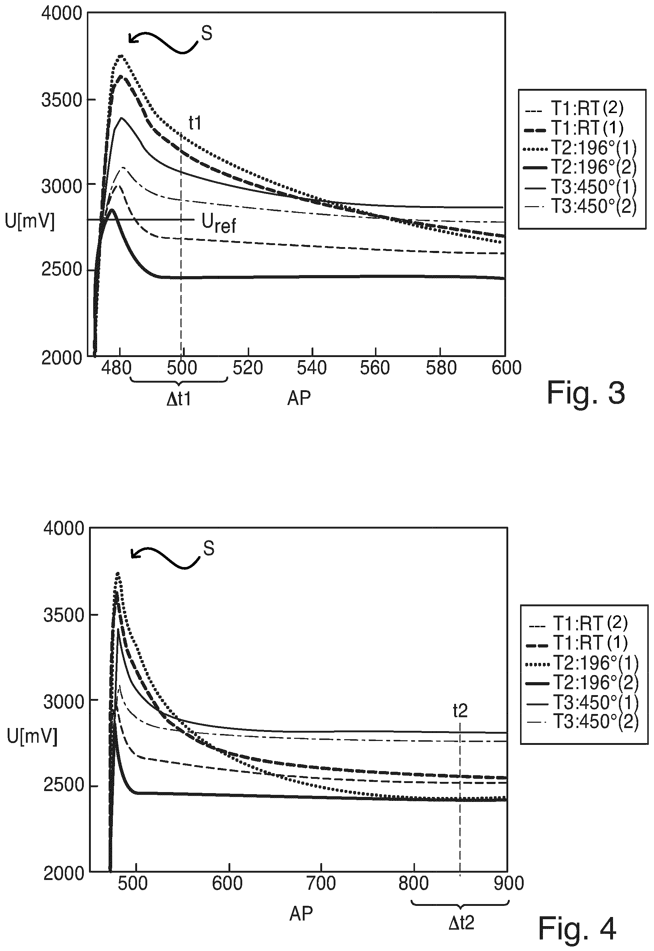

Eine Ausgestaltung der erfindungsgemäßen Zustandsüberwachung der Spule 17 ist in Fig. 3 illustriert. Dargestellt ist jeweils das Empfangssignal U der Spule 17 als Funktion des Abtastpunkts AP, im Prinzip also als Funktion der Zeit, für unterschiedliche Temperaturen T1, T2 und T3 und für eine voll funktionsfähige Spule (1) und eine teilweise kurzgeschlossene Spule (2). Der vorgebbare erste Messzeitpunkt t1 liegt für die gezeigte Ausgestaltung bei AP=500 und ist so gewählt, dass er in einem vorgebbaren ersten Zeitintervall Δt1 liegt, in welchem eine Sprungantwort S des Empfangssignals U in Folge einer sprunghaften Änderung des Anregesignals A [hier nicht dargestellt] detektierbar ist. Bei dem Anregesignal A handelt es sich beispielsweise um ein Rechtecksignal und die Sprungantwort S des Empfangssignals U erfolgt in Reaktion auf eine aufsteigende oder abfallende Flanke des Anregesignals.

Der erste Messzeitpunkt t1 wird so gewählt, dass er zeitlich nach dem Sprung S des Empfangssignals U liegt. Für die hier gezeigte Ausgestaltung liegt der erste Messzeitpunkt t1 in einem Bereich, in welchem das Empfangssignal U nach der Sprungantwort S exponentiell abklingt. Der gezeigte Verlauf entspricht dabei einer aufsteigenden Flanke des Anregesignals A.

Aus dem Diagramm ist ersichtlich, dass zu dem ersten Messzeitpunkt t1 die Werte für das Empfangssignal U für alle gewählten Temperaturen T1 ,T2,T3 für die funktionsfähigen Spulen 17 (1) jeweils größer ist als für die teilweise kurzgeschlossenen Spulen (2). Es lässt sich in diesem Bereich, also im Bereich des ersten Messintervalls Δt1, ein Referenzwert U_{ref} festlegen, der so beschaffen ist, dass alle Werte U>U_{ref} für das Empfangssignal U funktionsfähigen Spulen 17 entsprechen und alle Werte U<U_{ref} für das Empfangssignal U teilweise kurzgeschlossenen Spulen entsprechen. Unterschreitet ein erster Wert für das Empfangssignal U1 zu dem vorgebbaren ersten Messzeitpunkt t1 also den Referenzwert U_{ref}, so kann aus dem Unterschreiten auf das Vorliegen eines Teilkurzschlusses im Bereich der Spule 17 geschlossen werden.

Es können mittels des erfindungsgemäßen Verfahrens aber auch andere Aussagen über den Zustand der Spule 17 generiert werden. Beispielsweise kann anhand eines Vergleichs der Sprungantwort S mit einer Referenzsprungantwort S_{ref} auf das Vorliegen einer mangelhaften elektrischen Kontaktierung oder eines Kabelbruchs im Bereich der Spule erkannt werden.

Außerdem erlaubt das erfindungsgemäße Verfahren in einer weiteren Ausgestaltung, eine Aussage über die Temperatur T des Mediums 4 in dem Behälter 5 zu machen. Hierzu wird ein zweiter Wert U2 des Empfangssignals U zu einem zweiten vorgebbaren Messzeitpunkt t2 ermittelt, wie in Fig. 4 dargestellt. Wie in Fig. 3 sind in Fig. 4 Verläufe für das Empfangssignal U für drei unterschiedliche Temperaturen T1, T2, T3 und jeweils für eine funktionsfähige Spule 17 (1) und eine teilweise kurzgeschlossene Spule 17 (2) gezeigt. In einem zweiten vorgebbaren Zeitintervall Δt2, welcher außerhalb des ersten Zeitintervalls Δt1 liegt, weist das Empfangssignal U jeweils einen im Wesentlichen konstanten Wert auf. Dabei unterscheiden sich die Werte für die Empfangssignale U für jede der gewählten Temperaturen T1, T2, T3. Bei gleicher Temperatur T unterscheiden sich die Werte für die Empfangssignale U für funktionsfähige Spulen 17 (1) und solche, die zumindest teilweise kurzgeschlossen sind (2), dagegen kaum. Es lässt sich demnach anhand eines zweiten Werts U2 für das Empfangssignals U zu dem zweiten vorgebbaren Messzeitpunkt t2 eine Aussage über die Temperatur T des Mediums 4 ableiten, beispielsweise durch einen Vergleich des zweiten Werts U2 für das Empfangssignal U mit einer Kennlinie für das Empfangssignal U als Funktion der Temperatur T, welche beispielsweise in der Elektronikeinheit 7 der Vorrichtung 1 hinterlegt sein kann.

Zusammenfassend ermöglicht die vorliegende Erfindung eine Zustandsüberwachung für einen vibronischen Sensor 1 und ggf. zusätzlich eine Bestimmung der Temperatur T des Mediums 4 auf besonders einfache Weise und insbesondere ohne Integration weiterer Komponenten in den vibronischen Sensor 1. Die Zustandsüberwachung kann parallel oder abwechselnd zum normalen Messbetrieb des Sensors 1 erfolgen.

### Bezugszeichenliste

- 1: Vibronischer Sensor
- 2: Sensoreinheit
- 3: Schwingfähige Einheit
- 4: Medium
- 5: Behältnis
- 6: Antriebs-/Empfangseinheit
- 7: Elektronikeinheit
- 8: Membran der schwingfähigen Einheit
- 9: Schwingelement
- 10a, 10b: Schwingstäbe
- 11a, 11b: Paddel
- 12: Gehäuse der elektromechanischen Wandlereinheit
- 15a-15c: Stangen
- 16a-16c: Magnete
- 17: Spule
- 18: Kern der Spule
- 19: topfförmige Ankereinheit
- 20: Boden
- 21: Umfangsbewandung

- T,T1-T3: Temperatur des Mediums
- A: Anregesignal
- U: Empfangssignal
- U1, U2: Werte für das Empfangssignal
- .....U_{ref}: Referenzwert für das Empfangssignal
- Δt1 , Δt2: vorgebbares Zeitintervall
- t1,t2: Messzeitpunkt
- AP: Abtastpunkt
- f, f₁-f₃: Frequenz des Anregesignals
- S: Sprungantwort

## Patentansprüche

1. Verfahren zur Zustandsüberwachung einer Spule (17), welche Spule (17) Teil einer Vorrichtung (1) zur Bestimmung zumindest einer Prozessgröße eines Mediums (4) in einem Behälter (5) ist, umfassend folgende Verfahrensschritte
- Beaufschlagen der Spule (17) mit einem elektrischen Anregesignal (A) und Empfangen eines elektrischen Empfangssignals (U) von der Spule (17),
- Ermitteln eines ersten Werts (U1) für das Empfangssignal (U) zu einem ersten vorgebbaren Messzeitpunkt (t1),
- Vergleichen des ersten Werts (U1) für das Empfangssignals (U) zu dem ersten Messzeitpunkt (t1) mit einem Referenzwert (Uref), und
- Ermitteln eines Zustandsindikators für die Spule (17) anhand des Vergleichs,
wobei es sich bei dem Zustandsindikator um eine Aussage über eine mangelhafte elektrische Kontaktierung oder um einen Kabelbruch im Bereich der Spule (17) oder von zumindest zwei Anschlussdrähten handelt,
wobei das Vorliegen einer mangelhaften elektrischen Kontaktierung oder eines Kabelbruchs im Bereich der Spule (17) anhand einer Abweichung der Sprungantwort (S) des Empfangssignals (U) in Reaktion auf die sprunghafte Änderung des Anregesignals (A) von einer Referenzsprungantwort (S_{ref}) erkannt wird.

2. Verfahren nach Anspruch 1,
wobei der erste vorgebbare Messzeitpunkt (t1) so gewählt wird, dass er in einem vorgebbaren ersten Zeitintervall (Δt1) liegt, in welchem das Empfangssignal (U) in Form einer Sprungantwort (S) auf eine sprunghafte Änderung des Anregesignals (A) reagiert.

3. Verfahren nach Anspruch 1 oder 2,
wobei es sich bei dem Anregesignal (A) um ein Rechtecksignal handelt.

4. Verfahren nach Anspruch 2 und 3,
wobei es sich bei der sprunghaften Änderung des Anregesignals (A) um eine aufsteigende oder absinkende Flanke des Anregesignals (A) handelt.

5. Verfahren nach zumindest einem der vorherigen Ansprüche,
wobei es sich bei dem Zustandsindikator um eine Aussage über das Vorliegen zumindest eines Windungsschlusses im Bereich der Spule (17) handelt.

6. Verfahren nach Anspruch 5,
wobei das Vorliegen eines Windungsschlusses im Bereich der Spule (17) anhand eines Unterschreitens des Referenzwerts (U_{ref}) zum ersten vorgebbaren Messzeitpunkt (t1) erkannt wird.

7. Verfahren nach zumindest einem der vorherigen Ansprüche,
wobei ein zweiter Wert (U2) für das Empfangssignal (U) zu einem zweiten vorgebbaren Messzeitpunkt (t2) ermittelt wird, und wobei anhand des zweiten Werts (U2) für das Empfangssignal (U) eine Aussage über eine Temperatur (T) des Mediums (4) ermittelt wird.

8. Verfahren nach Anspruch 7,
wobei die Temperatur (T) des Mediums (4) anhand eines Vergleichs des zweiten Werts (U2) für das Empfangssignals (U) mit zumindest einer Kennlinie des Empfangssignals (U) als Funktion der Temperatur (T) ermittelt wird.

9. Verfahren nach einem der vorigen Ansprüche,
wobei der zweite vorgebbare Messzeitpunkt (t2) so gewählt wird, dass er außerhalb des ersten Zeitintervalls (Δt1) liegt.

10. Verfahren nach einem der vorigen Ansprüche,
wobei der zweite vorgebbare Messzeitpunkt (t2) so gewählt wird, dass er innerhalb eines zweiten Zeitintervalls (Δt2) liegt, in welchem das Empfangssignal (U) im Wesentlichen konstant ist.

11. Vorrichtung (1) zur Bestimmung und/oder Überwachung zumindest einer Prozessgröße eines Mediums (4) in einem Behältnis (5), umfassend zumindest eine Spule (17), welche Vorrichtung (1) dazu ausgestaltet ist, ein Verfahren nach zumindest einem der vorherigen Ansprüche durchzuführen.

12. Vorrichtung nach Anspruch 11,
wobei es sich bei der Vorrichtung (1) um einen vibronischen Sensor
umfassend
- eine mechanisch schwingfähige Einheit (4),
- eine Antriebs-/Empfangseinheit (6) mit zumindest einer Spule (17), welche Antriebs-/Empfangseinheit (6) dazu ausgestaltet ist, die mechanisch schwingfähige Einheit (4) mittels eines elektrischen Anregesignals (A) zu mechanischen Schwingungen anzuregen und die mechanischen Schwingungen von der schwingfähigen Einheit (4) zu empfangen und in ein elektrisches Empfangssignal (E) umzuwandeln, und
- eine Elektronikeinheit (7), welche dazu ausgestaltet ist, ausgehend vom Empfangssignal (E) das Anregesignal (A) zu erzeugen, und aus dem Empfangssignal (E) die zumindest eine Prozessgröße zu ermitteln,
handelt.

## Claims

1. Method for monitoring the state of a coil (17), which coil (17) is part of a device (1) for determining at least one process variable of a medium (4) in a container (5), comprising the following method steps:
- applying an electrical excitation signal (A) to the coil (17) and receiving an electrical received signal (U) from the coil (17),
determining a first value (U1) for the received signal (U) at a first predeterminable measurement time (t1),
comparing the first value (U1) for the received signal (U) at the first measurement time (t1) with a reference value (Uref), and
determining a status indicator for the coil (17) on the basis of the comparison,
the state indicator being a statement about a defective electrical contact or a cable break in the area of the coil (17) or of at least two connecting wires,
wherein the presence of a defective electrical contact or a cable break in the area of the coil (17) is detected on the basis of a deviation of the step response (S) of the received signal (U) in response to the step change of the excitation signal (A) from a reference step response (S_{ref}).

2. Method according to claim 1,
wherein the first predeterminable measurement time (t1) is selected such that it lies in a predeterminable first time interval (Δt1) in which the received signal (U) reacts in the form of a step response (S) to a step change in the excitation signal (A).

3. Method according to claim 1 or 2,
wherein the excitation signal (A) is a square-wave signal.

4. Method according to claim 2 and 3,
wherein the abrupt change in the excitation signal (A) is an ascending or descending edge of the excitation signal (A).

5. Method according to at least one of the previous claims,
wherein the state indicator is a statement about the presence of at least one interturn fault in the area of the coil (17).

6. Method according to claim 5,
wherein the presence of a turn-to-turn fault in the region of the coil (17) is detected on the basis of the reference value (U_{ref}) being undershot at the first predeterminable measurement time (t1).

7. Method according to at least one of the previous claims,
wherein a second value (U2) for the received signal (U) is determined at a second predeterminable measurement time (t2), and wherein a statement about a temperature (T) of the medium (4) is determined on the basis of the second value (U2) for the received signal (U).

8. Method according to claim 7,
wherein the temperature (T) of the medium (4) is determined by means of a comparison of the second value (U2) for the received signal (U) with at least one characteristic curve of the received signal (U) as a function of the temperature (T).

9. Method according to one of the previous claims,
wherein the second predeterminable measurement point in time (t2) is selected such that it lies outside the first time interval (Δt1).

10. Method according to one of the previous claims,
wherein the second predeterminable measurement time (t2) is selected such that it lies within a second time interval (Δt2) in which the received signal (U) is essentially constant.

11. Device (1) for determining and/or monitoring at least one process variable of a medium (4) in a container (5), comprising at least one coil (17), which device (1) is configured to carry out a method according to at least one of the previous claims.

12. Device according to claim 11,
wherein the device (1) is a vibronic sensor
comprising
- a mechanically vibratable unit (4),
- a drive/receive unit (6) having at least one coil (17), which drive/receive unit (6) is designed to excite the mechanically vibratable unit (4) to mechanical vibrations by means of an electrical excitation signal (A) and to receive the mechanical vibrations from the vibratable unit (4) and to convert them into an electrical receive signal (E), and
- an electronic unit (7) which is designed to generate the excitation signal (A) on the basis of the received signal (E) and to determine the at least one process variable from the received signal (E),
acts.

## Revendications

1. Procédé de surveillance de l'état d'une bobine (17), laquelle bobine (17) fait partie d'un dispositif (1) pour déterminer au moins une grandeur de processus d'un milieu (4) dans un récipient (5), comprenant les étapes de procédé suivantes
- Application d'un signal d'excitation électrique (A) à la bobine (17) et réception d'un signal de réception électrique (U) de la bobine (17),
- Détermination d'une première valeur (U1) pour le signal de réception (U) à un premier moment de mesure (t1) pouvant être prédéfini,
- Comparaison de la première valeur (U1) pour le signal de réception (U) au premier moment de mesure (t1) avec une valeur de référence (Uref), et
- Détermination d'un indicateur d'état pour la bobine (17) à l'aide de la comparaison, l'indicateur d'état étant une indication d'un contact électrique défectueux ou d'une rupture de câble dans la zone de la bobine (17) ou d'au moins deux fils de raccordement,
la présence d'un contact électrique défectueux ou d'une rupture de câble dans la zone de la bobine (17) étant détectée à l'aide d'un écart de la réponse à échelon (S) du signal de réception (U) en réaction à la modification à échelon du signal d'excitation (A) par rapport à une réponse à échelon de référence (_{Sref}).

2. Procédé selon la revendication 1,
dans lequel le premier instant de mesure (t1) pouvant être prescrit est choisi de manière à se situer dans un premier intervalle de temps (Δt1) pouvant être prescrit, dans lequel le signal de réception (U) réagit sous la forme d'une réponse à saut (S) à une variation brusque du signal d'excitation (A).

3. Procédé selon la revendication 1 ou 2,
dans lequel le signal d'excitation (A) est un signal carré.

4. Procédé selon les revendications 2 et 3,
dans lequel la variation brusque du signal d'excitation (A) est un flanc ascendant ou descendant du signal d'excitation (A).

5. Procédé selon au moins l'une des revendications précédentes,
dans lequel l'indicateur d'état est une indication de la présence d'au moins un court-circuit entre spires dans la zone de la bobine (17).

6. Procédé selon la revendication 5,
dans lequel la présence d'un court-circuit entre spires dans la zone de la bobine (17) est détectée à l'aide d'une valeur inférieure à la valeur de référence (_{Uref}) au premier instant de mesure (t1) pouvant être prédéfini.

7. Procédé selon au moins l'une des revendications précédentes,
dans lequel on détermine une deuxième valeur (U2) pour le signal de réception (U) à un deuxième instant de mesure (t2) pouvant être prédéfini, et dans lequel on détermine une information sur une température (T) du milieu (4) à l'aide de la deuxième valeur (U2) pour le signal de réception (U).

8. Procédé selon la revendication 7,
la température (T) du milieu (4) étant déterminée à l'aide d'une comparaison de la deuxième valeur (U2) pour le signal de réception (U) avec au moins une courbe caractéristique du signal de réception (U) en fonction de la température (T).

9. Procédé selon l'une des revendications précédentes,
dans lequel le deuxième instant de mesure (t2) pouvant être prescrit est choisi de telle sorte qu'il se situe en dehors du premier intervalle de temps (Δt1).

10. Procédé selon l'une des revendications précédentes,
dans lequel le deuxième instant de mesure (t2) pouvant être prescrit est choisi de manière à se situer à l'intérieur d'un deuxième intervalle de temps (Δt2) dans lequel le signal de réception (U) est sensiblement constant.

11. Dispositif (1) de détermination et/ou de surveillance d'au moins une grandeur de processus d'un fluide (4) dans un récipient (5), comprenant au moins une bobine (17), lequel dispositif (1) est configuré pour mettre en oeuvre un procédé selon au moins l'une des revendications précédentes.

12. Dispositif selon la revendication 11,
dans lequel le dispositif (1) est un capteur vibratoire
comprenant
- une unité mécaniquement vibrante (4),
- une unité d'entraînement/réception (6) avec au moins une bobine (17), laquelle unité d'entraînement/réception (6) est configurée pour exciter l'unité mécaniquement vibrante (4) en vibrations mécaniques au moyen d'un signal d'excitation électrique (A) et pour recevoir les vibrations mécaniques de l'unité vibrante (4) et les convertir en un signal de réception électrique (E), et
- une unité électronique (7) qui est conçue pour générer le signal d'excitation (A) à partir du signal de réception (E) et pour déterminer l'au moins une grandeur de processus à partir du signal de réception (E),
agit.
